Europäisches Patentamt

European Patent Office

Office européen des brevets

(19)

(11) Numéro de publication: **0 235 025 B1**

(12)

# FASCICULE DE BREVET EUROPEEN

(45) Date de publication du fascicule du brevet:
18.07.90

(51) Int. Cl.⁵: **H01L 23/31, H01L 23/48**

(21) Numéro de dépôt: **87400298.3**

(22) Date de dépôt: **10.02.87**

(54) Composant semiconducteur et procédé d'encapsulation correspondant.

(30) Priorité: **14.02.86 FR 8602054**

(43) Date de publication de la demande:
**02.09.87 Bulletin 87/36**

(45) Mention de la délivrance du brevet:
**18.07.90 Bulletin 90/29**

(84) Etats contractants désignés:
**DE FR GB IT NL**

(56) Documents cités:
**DE-A- 2 351 997**

(73) Titulaire: **THOMSON-CSF, 51, Esplanade du Général de Gaulle, F-92800 Puteaux(FR)**

(72) Inventeur: **Barre, Lucien, THOMSON-CSF SCPI 19, avenue de Messine, F-75008 Paris(FR)**

(74) Mandataire: **de Beaumont, Michel et al, 1bis, rue Champollion, F-38000 Grenoble(FR)**

ACTORUM AG

## Description

L'invention concerne un nouveau type de boitier d'encapsulation de composant semiconducteur.

Un but de l'invention est de réaliser un composant dont le boitier est aussi peu coûteux que possible.

Un autre but est de réaliser un composant qui soit montable en surface d'une plaque de circuit imprimé. Par composant montable en surface, on entend un composant dont la structure est telle qu'il peut être soudé, par ses électrodes, sur la surface d'une plaque de circuit imprimé sans qu'il soit nécessaire de percer la plaque de trous dans lesquels viendraient s'enfiler les électrodes du composant.

Un autre but encore est de réaliser un composant dont les dimensions sont aussi réduites que possible (compte-tenu naturellement de la taille de la pastille semiconductrice qu'il contient), et notamment un composant dont la hauteur par rapport à la surface de la plaque de circuit imprimé est aussi faible que possible lorsque le composant est monté sur cette plaque.

Enfin, un autre but de l'invention est de réaliser un composant dont la fabrication puisse être mieux automatisée que celle des composants existant actuellement.

On expliquera l'invention essentiellement à propos d'un composant semiconducteur comportant simplement une pastille semiconductrice et deux électrodes soudées respectivement sur la face inférieure et la face supérieure de la pastille, et on expliquera ensuite comment l'invention pourrait être étendue à des composants incorporant éventuellement plusieurs pastilles semiconductrices.

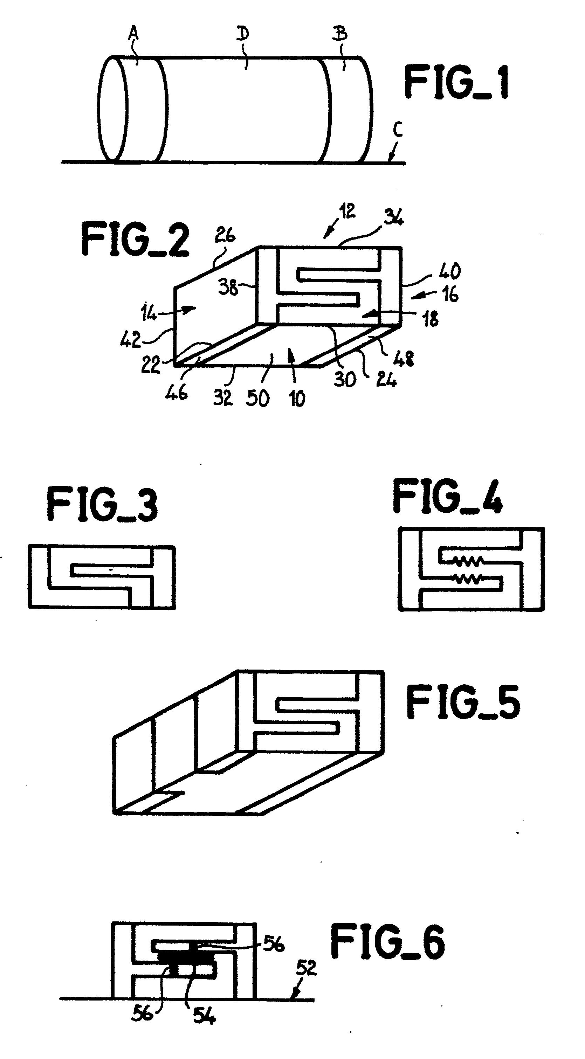

Des composants montables en surface de coût très réduit, tels que des diodes de faible puissance, sont constitués habituellement selon la structure représentée à la figure 1.

Dans ces composants, on trouve une pastille semiconductrice soudée entre deux électrodes en forme de pistons, dont les extrémités A et B (têtes des pistons) pourront être soudées sur la plaque de circuit imprimé C. La pastille semiconductrice est noyée dans une résine D qui forme le corps principal du composant d'où émergent les extrémités des électrodes. A l'intérieur du composant, la pastille est située dans un plan perpendiculaire au plan de la plaque de circuit imprimé, d'où il résulte que si le corps de résine est cylindrique, il a nécessairement un diamètre au moins égal à la plus grande dimension diagonale de la pastille semiconductrice (qui est en général carrée).

Le montage en boitier ci-dessus est celui qui a été adopté jusqu'à ce jour parce qu'il est particulièrement simple et économique.

Un composant montable en surface est décrit dans le document DE-A 2 351 997. Il s'agit d'une structure adaptée à une pastille semiconductrice à trois électrodes. La pastille est soudée par sa face arrière à une grille de connexion et des bornes de cette pastille sont raccordées par les conducteurs à des emplacements de la grille de connexion. Ensuite des pattes de la grille de connexion sont repliées pour former des bornes situées dans un même plan.

La Demanderesse a recherché de nouvelles manières de réaliser des montages simples et économiques, en essayant de réaliser les objectifs indiqués précédemment, et elle est parvenue à une solution très différente de la technique habituelle et présentant des avantages remarquables quant à la simplicité de fabrication, au coût, à l'encombrement (notamment dans le sens vertical) et à la possibilité de mieux automatiser la production.

La solution est un montage en boitier de type nouveau, et un procédé de fabrication pour le réaliser.

Le nouveau composant a trois particularités:

– d'une part la disposition horizontale (c'est-à-dire parallèle au plan de la plaque de circuit imprimé), et non verticale, de la pastille semiconductrice,

– d'autre part la structure en profilé métallique des électrodes, c'est-à-dire que chaque électrode a une section essentiellement constante sur toute sa longueur,

– enfin, la forme globale du composant est un parallèlépipède dont deux faces latérales sont délimitées par les électrodes et dont les autres faces sont délimitées par de la résine et des portions d'électrodes (les électrodes ne faisant pas saillie par rapport à ce parallèlépipède).

Plus précisément, le composant selon l'invention comporte les particularités énoncées en revendication 1.

En pratique la section transversale de chaque électrode aura de préférence la forme d'un T couché dissymétrique, une branche horizontale du T servant au contact avec la pastille semiconductrice à l'intérieur du composant et l'autre constituant une face latérale (gauche pour la première électrode, droite pour la deuxième) du composant et affleurant aussi sur la face inférieure pour permettre la soudure du composant sur la plaque de circuit imprimé.

La fabrication de ce composant est particulièrement aisée grâce à un procédé de fabrication nouveau qui consiste à:

– utiliser des électrodes constituées chacune par un profilé métallique de section transversale constante;

– souder la pastille entre les deux profilés ;

– placer l'ensemble soudé dans un moule d'injection de résine, les profilés et le moule délimitant un espace d'injection parallèlépipédique dont une partie est occupée par les profilés et la pastille, l'une des faces du parallèlépipède étant parallèle à la pastille et les deux électrodes affleurant sur cette face.

– injecter de la résine dans le moule

– scier les profilés et la résine entre des pastille consécutives.

D'autres caractéristiques et avantages de l'invention apparaîtront à la lecture de la description détaillée qui suit et qui est faite en référence au dessin annexé dans lequel :

- la figure 1 déjà décrite représente un composant classique montable en surface,
- la figure 2 représente en perspective une vue extérieure du composant selon l'invention,
- les figures 3 et 4 représentent en vue transversale d'autres modes de réalisation,
- la figure 5 représente en perspective une autre réalisation,
- la figure 6 représente une coupe du composant selon un mode de réalisation,
- la figure 7 représente schématiquement une phase de procédé de fabrication selon l'invention,
- la figure 8 représente une autre phase du procédé de fabrication.

Le composant semiconducteur selon l'invention est représenté à la figure 2 en perspective. Pour mieux faire comprendre sa structure et son apparence extérieure, on a représenté par des zones hachurées les surfaces de résine plastique du boîtier et par des zones non hachurées les portions métalliques qui sont des portions d'électrodes visibles extérieurement.

Pour faciliter la description on a désigné par des noms spécifiques les six faces de parallélépipède constituant le composant. Ces faces sont respectivement :

- une face inférieure 10 (en bas sur la figure 2),
- une face supérieure 12 parallèle à la face inférieure,
- une face latérale gauche 14 (à gauche sur la figure 2),
- une face latérale droite 16 parallèle à la face latérale gauche,
- une face transversale avant 18,
- une face transversale arrière (20) parallèle à la face transversale avant.

Sont visibles sur la figure 2 la face inférieure 10, la face latérale gauche 14, et la face transversale avant 18 ; les autres faces sont cachées compte tenu de la direction d'observation choisie dans la vue en perspective.

La face inférieure 10 est celle qui reposera sur la plaque de circuit imprimé lorsque le composant sera soudé en place.

Toujours pour faciliter la description, on a appelé arêtes longitudinales les arêtes du parallélépipède parallèles à une direction longitudinale (perpendiculaire aux faces transversales) ; il y a deux arêtes longitudinales 22 et 24 sur la face inférieure et deux arêtes longitudinales dont l'une, 26, est visible, sur la face supérieure.

On a appelé arêtes horizontales transversales les arêtes du parallélépipède perpendiculaires aux faces latérales ; il y a deux arêtes horizontales transversales 30 et 32 sur la face inférieure 10 et deux arêtes horizontales transversales dont l'une 34, est visible, sur la face supérieure 12.

Et enfin on a appelé arêtes verticales les arêtes perpendiculaires aux faces inférieure et supérieure ; il y a deux arêtes verticales avant 38 et 40 sur la face transversale avant et deux arêtes verticales arrières dont l'une, 42, est visible, sur la face arrière.

Vu de l'extérieur, le composant est constitué de la manière suivante :

- les faces latérales 14 et 16 sont constituées chacune par une surface métallique appartenant à une électrode (en principe, à chaque face correspond une électrode respective),
- la face inférieure est divisée en plusieur bandes rectangulaires s'étendant parallèlement les unes aux autres dans la direction longitudinale ; ces bandes comprenant respectivement une zone d'affleurement 46 de la première électrode du composant, une zone d'affleurement 48 de la seconde électrode, et au moins une zone de résine 50 séparant les deux zones d'affleurement 46 et 48. Ces trois zones rectangulaires parallèles sont situées dans un même plan qui constitue la face inférieure 10 du composant, c'est-à-dire que les électrodes affleurent sur cette face sans faire saillie ;
- la face supérieure comprend en principe également plusieurs zones qui sont respectivement des zones d'affleurement d'une ou des deux électrodes et une zone de résine qui les sépare,
- chaque face transversale comprend des zones d'affleurement des deux électrodes et des zones de résine qui les séparent, toutes ces zones affleurant encore dans un même plan qui est le plan de la face transversale considérée ;
- les électrodes sont chacune constituée d'un profilé métallique s'étendant dans la direction longitudinale (perpendiculairement aux faces transversales), c'est-à-dire que chaque électrode a une section transversale sensiblement constante sur toute sa longueur dans cette direction longitudinale.

Par section sensiblement constante on entend une section constante telle qu'on peut l'obtenir pour des profilés formés par étirage, avec en outre des possibilités de variations locales mineures de section telles que celles qui existeraient si l'on perçait des petits trous de place en place dans le profilé ou si l'on faisait des encoches de repérage etc...

Dans l'exemple représenté à la figure 2, qui est le mode de réalisation préféré, chaque électrode a une section transversale à deux branches, en forme de T couché dissymétrique ; cette section apparaît à nu sur les faces transversales du composant ; l'une des branches de la section transversale du profilé est horizontale, donc parallèle à la face inférieure 10 ; elle correpond à une partie de profilé plane s'étendant parallèlement à la face inférieure du composant ; l'autre branche de la section transversale du profilé est verticale donc parallèle aux faces latérales ; elle correspond à une autre partie de profilé plane formant une face latérale (gauche pour la première électrode, droite pour la seconde) du profilé.

La branche horizontale de la première électrode est espacée de la branche horizontale de la deuxième électrode, l'intervalle entre les deux correspondant à l'épaisseur de la pastille semiconductrice (y compris les épaisseurs de soudure nécessaires) contenue dans le boîtier.

La pastille semiconductrice, non visible puisqu'elle est noyée dans la résine, est en effet placée parallèlement à la face inférieure, entre les deux branches horizontales des électrodes.

Dans ce mode de réalisation la zone d'affleurement 46 de la première électrode sur la face inférieure s'étend le long de l'arête longitudinale inférieure 22, tandis que la zone d'affleurement 48 de la seconde électrode sur la face inférieure s'étend le long de l'autre arête longitudinale inférieure 24. De la résine s'étend dans l'espace (50) entre ces deux zones 46 et 48.

L'aspect extérieur du composant de la figure 2 du coté des faces cachées (face supérieure 12, face droite 16, et face arrière 20) n'est pas représenté, mais il se déduit de l'aspect des autres si l'on se réfère à ce qui a été dit ci-dessus, à savoir principalement le fait que la section transversale des électrodes, visible sur la face avant 18, est constante sur toute la longueur du composant : la face droite 16 est semblable à la face gauche 14 et elle est constituée par une partie verticale de la deuxième électrode ; la face supérieure 12 est semblable à la face inférieure 10 ; et la face arrière 20 est semblable à la face avant (en fait elle en est symétrique).

Des variantes de sections transversales d'électrodes peuvent être imaginées ; la figure 3 en montre un exemple, par une représentation de la face transversale avant qui en résulte ; cet exemple est plutôt adapté à un composant nécessitant une meilleure dissipation thermique vers la plaque de circuit imprimé, car l'une des électrodes a une large surface affleurant sur la face inférieure.

Les variantes de sections transversales d'électrodes auront en commun la présence d'une branche horizontale sur chaque électrode, les branches des deux électrodes étant en regard l'une de l'autre et espacées d'une distance telle que l'on puisse souder à plat la pastille semiconductrice entre les branches horizontales en regard. Le terme horizontal signifie ici parallèle à la face inférieure du composant. Les variantes de sections transversales auront aussi en commun la présence de branches verticales constituant la totalité ou quasi totalité des faces latérales du composant. On peut imaginer toutefois que ce soit la même électrode qui a deux branches verticales (section en U renversé) constituant les deux faces latérales, l'autre électrode n'ayant pas de branche verticale.

D'autres variantes peuvent être imaginées sans sortir du cadre de l'invention.

En particulier on peut prévoir que les branches horizontales des électrodes profilées ne sont pas planes mais crénelées ou rainurées sur leurs faces destinées à recevoir la pastille semiconductrice, de manière à faciliter l'étalement de la soudure lors de la mise en place et le soudage de la pastille entre les profilés. La figure 4 en représente un exemple.

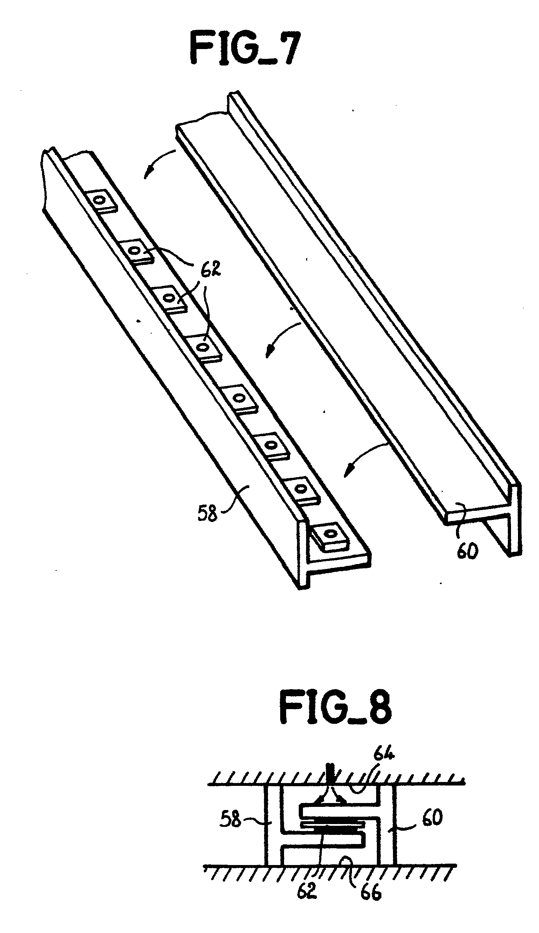

On peut enfin imaginer que le composant soit un composant à deux ou quatre électrodes (ou plus), dans lequel sont noyées deux pastilles semiconductrices, reliées à des électrodes séparées (une électrode pouvant être commune aux deux pastilles). La figure 5 représente, dans une vue analogue à la figure 2, l'aspect extérieur qui en résulterait (composant à deux pastilles et une électrode commune) ; l'une des pastilles est située àl'avant du composant, l'autre à l'arrière ; dans ce cas, le profilé constituant l'électrode affleurant sur la face latérale gauche est scié entre les deux pastilles (avant moulage de la résine) pour séparer le profilé en deux électrodes affleurant le long de la même arête du parallèlépipède ; il faut d'ailleurs noter que dans ce cas, l'autre électrode, affleurant sur la face latérale droite, même si elle n'est pas divisée en deux électrodes complètement distinctes, peut avoir sa branche horizontale sciée sans inconvénient en même temps que la branche horizontale de la première électrode.

Pour mieux faire comprendre la structure du composant de la figure 2, on a représenté à la figure 6 une coupe transversale de ce composant au milieu du boitier à travers lapastille semiconductrice ; le composant est représenté posé sur une plaque de circuit imprimé horizontale 52 et on voit que la pastille semiconductrice, désignée par 54, est placée à plat parallèlement à la face inférieure du boitier du composant, c'est-à-dire parallèlement à la plaque de circuit imprimé. On notera que des trous 56 peuvent être percés dans les électrodes au-dessus de la pastille pour permettre une évacuation de trop-plein de soudure.

Ce boitier est particulièrement adapté à des composants de très faible puissance, donc de très petites dimensions ; ;aga titre d'exemple, la hauteur du composant peut être de 2,5 millimètres environ en supposant que l'espace entre les électrodes est de 0,4 millimètre (pour loger l'épaisseur classique de 0,25 millimètres d'une pastille semiconductrice et la soudure), et en supposant que les électrodes ont des branches horizontales d'une épaisseur de 0,4 millimètre.

La hauteur du composant n'est pas liée à la surface de la pastille contrairement au cas général des composants montables eh surface proposés jusqu'à maintenant.

La limitation de la hauteur même pour des puces de dimensions importantes est un avantage important pour deux raisons :

— les cartes de circuit imprimé doivent être mises côte à côte dans des systèmes complexes et leur espacement est fonction de la hauteur des composants qu'elles portent ; en réduisant la hauteur des composants on améliore l'encombrement global du système ;

— les cartes de composants sont très souvent encore soudées à la vague ; mais contrairement au cas des composants "insérables" (dont les électrodes passent à travers des trous du circuit imprimé et sont soudées par la face arrière de la plaque), les cartes de composants montés en surface sont soudées à la vague par la face avant en retournant la plaque pour que les composants soient mouillés par la soudure ; mais alors, la hauteur des composants ne peut excéder la hauteur de la vague de soudure (3 à 4 millimètres).

Parmi les autres avantages de la structure du composant selon l'invention, on peut citer :

– facilité de préhension par une pince (faces latérales planes et parallèles);

– facilité de préhension par succion (face supérieure large et plane),

– stabilité du composant sur la plaque de circuit imprimé avant soudure (face inférieure plane et large),

– facilité de marquage ineffaçable sur la face supérieure (marquage au laser plus facile sur une surface plane et large) ; le marquage reste visible après mise en place du composant.

Et surtout, comme on va le voir ci-après, les avantages de cette structure de composant résident dans la facilité de fabrication et dans la réduction du coût des appareils nécessaires à la fabrication (notamment le moule pour la résine).

Pour la fabrication, on part de deux profilés métalliques, de préférence en cuivre, obtenus par étirage (pas d'usinage par enlèvement de matière d'où uncoût réduit pour le matériau utilisé) ; ces profilés ayant les sections décrites ci-dessus, c'est-à-dire essentiellement en T couché dissymétrique dans le mode de réalisation préféré.

On peut monter un grand nombre de pastilles semiconductrices sur ces profilés avec une seule opération de moulage suivie d'un sciage des profilés et de la résine pour individualiser les composants, d'où une facilité de manipulation pendant une partie de la fabrication.

Entre les branches horizontales des profilés on soude de place en place une pastille semiconductrice de la manière suivante : une petite quantité de pâte de soudure est déposée de place en place sur l'un des profilés et des pastilles semiconductrices sont posées à ces endroits ; une petite quantité de soudure est redéposée sur le dessus des pastilles ou de place en place sur le deuxième profilé ; les deux profilés sont placés en regard l'un de l'autre dans la position qu'ils doivent occuper finalement. L'ensemble est soudé par un traitement thermique approprié à la nature de la pâte de soudure déposée. La figure 7 schématise l'opération de mise en place d'un profilé (60) sur l'autre (58), les puces (62) étant en place sur le premier profilé.

L'ensemble ainsi soudé est placé à l'intérieur d'un moule d'injection de résine qui a la particularité de ne nécessiter comme surface rectifiée de moulage que des surfaces planes et non des surfaces usinées en creux comme c'est le cas pour les moules habituellement utilisés pour l'encapsulation des composants semiconducteurs.

En effet l'espace d'injection de résine destiné à délimiter le composant de forme parallèlépipédique est formé non seulement par les faces planes du moule (délimitant la face supérieure et la face inférieure du composant), mais aussi par les profilés eux-mêmes et plus précisément par leurs branches qui correspondent aux faces latérales du composant ; la hauteur du profilé détermine la distance séparant les deux surfaces du moule que l'on referme sur les profilés.

Le prix d'usinage des surfaces rectifiées d'un moule en creux est très élevé, or ces surfaces s'usent car elles sont soumises à l'abrasion de la résion. L'usinage de surfaces planes constitue une économie appréciable.

La figure 8 schématise l'opération de moulage par injection de résine : on y voit les surfaces usinées planes 64 et 66 du moule et l'ensemble des profilés avec les pastilles (vus en coupe transversale) ; les surface usinées du moule viennent en appui sur les extrémités des faces latérales des profilés et délimitent alors avec ces faces latérales un espace d'injection parallélépipédique pour la résine. Les extrémités en bout de profilé peuvent être fermées par des blocs de matière souple élastomère (à base de silicone).

Après moulage de la résine, les profilés sont sciés de place en place entre les pastilles semiconductrices (sciage des profilés et de la résine) pour former des composants individuels tels que ceux de la figure 2. Ces composants peuvent être plongés dans un bain d'étamage électrolytique, à moins que le profilé n'ait été plongé dans un tel bain entre l'opération de moulage et l'opération de sciage.

Le procédé de fabrication de ce composant est donc particulièrement simple et peu coûteux.

**Revendications**

1. Composant semiconducteur montable en surface sur une plaque de circuit imprimé, comprenant une ou deux pastilles semiconductrice, une première électrode reliée à la face inférieure et une ou deux deuxièmes électrodes reliées à la face supérieure de la pastille, et une résine moulée enrobant la pastille et laissant émerger une extrémité de chaque électrode; le composant ayant une forme parallélépipédique avec une face inférieure (10) destinée à être appliquée contre une plaque de circuit imprimé, une face supérieure (12) parallèle à la face inférieure, une face latérale gauche (14), une face latérale droite (16) parallèle à la face gauche, une face transversale avant (18) et une face transversale arrière parallèle à la face avant; et la face inférieure (10) comprenant au moins une zone de résine (50) séparant une zone d'extrémité (46) de première électrode et une zone d'extrémité (48) de deuxième électrode, ces trois zones affleurant dans un même plan constituant la face inférieure (10) du composant, caractérisé en ce que:

– les électrodes sont constituées chacune par un profilé métallique ayant une section transversale, parallèle aux faces transversales, essentiellement constante sur toute leur longueur, chaque profilé comprenant une branche verticale, parallèle aux faces latérales, et une branche horizontale, parallèle aux faces supérieure et inférieure, et

– chaque pastille est prise en sandwich entre la branche horizontale du profilé de ladite première électrode et la branche horizontale du profilé de ladite au moins une deuxième électrode.

2. Composant selon la revendication 1, caractérisé en ce que la branche verticale de la première électrode constitue une face latérale du composant.

3. Composant selon la revendication 2, caractérisé en ce que la branche verticale de la deuxième électrode constitue l'autre face latérale du composant.

4. Composant selon l'une des revendication 1 à 3, caractérisé en ce que l'une au moins des électrodes affleure le long d'une arête longitudinale (perpendiculaire aux faces transversales) de la face inférieure du parallélépipède.

5. Composant selon la revendication 4, caractérisé en ce que l'autre électrode affleure le long d'une autre arête longitudinale (perpendiculaire aux face transversales) de la face inférieure du parallélépipède.

6. Procédé d'encapsulation de composants semiconducteurs montables en surface sur une plaque de circuit imprimé, comprenant les opérations de soudure de deux électrodes respectivement sur une face inférieure et une face supérieure d'une pastille semiconductrice puis de moulage d'une résine autour de la pastille en laissant dépasser des extémités des électrodes, caractérisé en ce que:
- les électrodes sont constituées chacune par une portion d'un profilé métallique ayant une section essentiellement constante le long du profilé,
- la face inférieure de la pastille est soudée sur l'un des profilés et la face supérieure sur l'autre,
- les profilés et la pastille sont placés dans un moule d'injection de résine, les profilés et le moule délimitant un espace d'injection parallèlépipédique dont deux faces latérales parallèles sont définies par les profilés et dont une face inférieure est parallèle à la pastille, les deux électrodes affleurant sur cette face inférieure,
- la résine est injectée dans cet espace parallèlépipédique.

7. Procédé selon la revendication 6, caractérisé en ce que l'un au moins des profilés comprend une branche parallèle à la pastille et une branche perpendiculaire, cette dernière délimitant complètement une face latérale de l'espace d'injection parallèlépipédique.

8. Procédé selon la revendication 7, caractérisé en ce que l'autre profilé comprend également une branche parallèle à la pastille et une branche perpendiculaire, cette dernière délimitant complètement l'autre face latérale de l'espace d'injection parallèlépipédique.

9. Procédé selon l'une des revendications 7 et 8, caractérisé en ce que le moule comporte deux surfaces usinées venant s'appliquer contre la branche perpendiculaire du profilé pour délimiter les faces supérieure et inférieure de l'espace d'injection parallèlépipèdique.

10. Procédé selon l'une des revendication 6 à 9, caractérisé en ce que des pastilles sont soudées de place en place le long des profilés, puis le moulage est effectué, puis les profilés et la résine sont sciés pour former des composant individuels séparés.

**Patentansprüche**

1. Halbleiterbauelement, das auf der Oberfläche einer gedruckten Schaltungsplatte montiert werden kann und das umfaßt: einen oder zwei Halbleiterchips, eine erste Elektrode, die an der Unterseite angeschlossen ist, und eine oder zwei zweite Elektrode(n), die an die Oberseite des Chips angeschlossen ist/sind, und gegossenen Harz, der den Chip umgibt und ein äußeres Gebiet der Elektrode freiliegen läßt; wobei das Element quaderförmig ist und eine Unterseite (10), die dazu bestimmt ist, auf eine Seite der gedruckten Schaltungsplatte aufgebracht zu werden, eine zur Unterseite parallele Oberseite (12), eine linke Seitenfläche (14), eine dazu parallele rechte Seitenfläche (16), eine vordere Stirnseite (18) und eine dazu parallele hintere Stirnseite aufweist, und wobei die Unterseite (10) mindestens ein Harzgebiet (50) aufweist, das ein Außengebiet (46) der ersten Elektrode und ein Außengebiet (48) der zweiten Elektrode trennt, und diese drei Gebiete miteinander in einer Ebene fluchten, welche die Unterseite (10) des Elementes bildet, dadurch gekennzeichnet, daß:
- die Elektroden jeweils von einem Metallprofil gebildet sind, das parallel zu den Stirnseiten einen im wesentlichen über die gesamte Länge konstanten Querschnitt aufweist, wobei jedes Profil einen zu den Seitenflächen parallelen vertikalen Steg und einen zu der Ober- und der Unterseite parallelen horizontalen Steg aufweist, und
- jeder Chip zwischen dem horizontalen Steg des Profils der ersten Elektrode und dem horizontalen Steg des Profils mindestens einer zweiten Elektrode geschichtet ist.

2. Element nach Anspruch 1, dadurch gekennzeichnet, daß der vertikale Steg der ersten Elektrode eine Seitenfläche des Elementes bildet.

3. Element nach Anspruch 2, dadurch gekennzeichnet, daß der vertikale Steg der zweiten Elektrode die andere Seitenfläche des Elementes bildet.

4. Element nach einem der Ansprüche 1 bis 3, dadurch gekennzeichnet, daß mindestens eine der Elektroden mit einer Längskante (senkrecht zu den Stirnseiten) der Unterseite des Quaders fluchtet.

5. Element nach Anspruch 4, dadurch gekennzeichnet, daß die andere Elektrode mit einer anderen Längskante (senkrecht zu den Stirnseiten) der Unterseite des Quaders fluchtet.

6. Verfahren, insbesondere zum Herstellen des Halbleiterelementes nach Anspruch 1, das folgende Schritte ümfaßt: Anlöten der beiden Elektroden jeweils an eine Unterseite und eine Oberseite eines Halbleiterchips, danach Gießen eines Harzes um den Chip herum, wobei die Außengebiete der Elektroden freibleiben, dadurch gekennzeichnet, daß:
- die Elektroden jeweils von einem Metallprofilabschnitt mit einem im wesentlichen über die Profillänge konstanten Querschnitt gebildet sind,
- die Unterseite des Chips an dem einen Profil und die Oberseite an dem anderen Profil angelötet werden,
- die Profile und der Chip in einer Spritzgußform für Harz angeordnet werden, wobei die Profile und die Form einen quaderförmigen Einspritzraum freilassen, dessen beide parallele Seitenflächen durch die Profile festgelegt sind und dessen eine Unterseite parallel zu dem Chip ist, und wobei die beiden Elektroden mit der Unterseite fluchten,

– das Harz in den quaderförmigen Raum eingespritzt wird.

7. Verfahren nach Anspruch 6, dadurch gekennzeichnet daß mindestens eines der Profile einen zu dem Chip parallelen Steg und einen dazu senkrechten Steg umfaßt, wobei der letztere eine Seitenfläche des quaderförmigen Einspritzraumes vollständig begrenzt.

8. Verfahren nach Anspruch 7, dadurch gekennzeichnet, daß das andere Profil ebenfalls einen zu dem Chip parallelen Steg und einen dazu senkrechten Steg umfaßt, wobei der letztere die andere Seitenfläche des quaderförmigen Einspritzraumes vollständig begrenzt.

9. Verfahren nach einem der Ansprüche 7 und 8, dadurch gekennzeichnet, daß die Form zwei feinbearbeitete Flächen umfaßt, die gegen den senkrechten Steg des Profils verbracht werden, um die Ober- und Unterseite des quaderförmigen Einspritzraumes festzulegen.

10. Verfahren nach einem der Ansprüche 6 bis 9, dadurch gekennzeichnet, daß die Chips in einer Reihe entlang den Profilen angelötet werden, danach gegossen wird und dann die Profile und das Harz gesägt werden, um gesonderte Elemente zu bilden.

**Claims**

1. A semiconductor component which can be mounted on the surface of a printed circuit board, comprising one or two semiconductor chip(s), a first electrode linked to a lower face and one or two second electrode(s) linked to an upper face of the chip and a molded resin which coats the chip and lets an end of each electrode emerge; the component having a parallelepiped shape with a lower face (10) designed to be applied against a printed circuit board, an upper face (12) parallel to the lower face, a left-hand side face (14), a right-hand side face (16) parallel to the left-hand face, a front transversal face (19) and a rear transversal face parallel to the front face; and the lower face (10) comprising at least one zone of resin (50) separating an end zone (46) of the first electrode from an end zone (48) of second electrode, said three zones being flush with one another in one and the same plane constituting the lower face of the component, characterized in this that
– the electrodes each comprise a metallic extrusion with a transversal cross-section, parallel to the transversal faces, which is essentially constant throughout its length, each extrusion comprising a vertical arm, parallel to the side faces, and an horizontal arm parallel to the upper and lower faces, and
– each chip is sandwiched between the horizontal arm of the extrusion of said first electrode and the horizontal arm of the extrusion of said at least one electrode.

2. A component according to claim 1, characterized in this that the vertical arm of the first electrode constitutes a side face of the component.

3. A component according to claim 2, characterized in this that the vertical arm of the second electrode constitutes the other side face of the component.

4. A component according to any of claims 1 to 3, characterized in this that at least one of the electrodes is exposed along and flush with a longitudinal edge (perpendicular to the transversal faces) of the lower face of the parallelepiped.

5. A component according to claim 4, characterized in this that the other electrode is exposed along and flush with another longitudinal edge (perpendicular to the transversal faces) of the lower face of the parallelepiped.

6. A method especially provided for the manufacturing of the semiconductor component according to claim 1, comprising the operations for soldering two electrodes to a lower face and an upper face respectively of a semiconductor chip and then for molding a resin around the chip while letting the ends of the electrodes protrude, characterized in this that:
– the electrodes are each made up of a portion of a metallic extrusion with a section which is essentially constant throughout the length of the extrusion,
– the lower face of the chip is soldered to one of the extrusions and the upper face to the other,
– the extrusions and the chip are placed in a resin injection mold, with the extrusions and the mold demarcating a parallelepiped-shaped injection space, two parallel side faces of which are defined by the extrusions and one lower face of which is parallel to the chip, the two electrodes being flush with this lower face,
– the resin is injected into this parallelepiped-shaped space,

7. A method according to claim 6, characterized in this that at least one of the extrusions comprises an arm which is parallel to the chip and a perpendicular arm, this latter arm completely demarcating a side face of a parallelepiped-shaped injection space.

8. A method according to claim 7, characterized in this that the other extrusion also comprises an arm which is parallel to the chip and a perpendicular arm, this latter arm completely demarcating the other parallelepiped-shaped injection space.

9. A method according to one of the claims 7 and 8, characterized in this that the mold comprises two machined surfaces which are applied against the perpendicular arm of the extrusion to demarcate the upper and lower faces of the parallelepiped-shaped injection space.

10. A method according to one of the claims 6 to 9, characterized in this that the chips are soldered from place to place along the extrusions, after which the molding is done, and after which the extrusions and the resin are sawn through to form separate, individual components.

FIG_1

FIG_2

FIG_3

FIG_4

FIG_5

FIG_6

# FIG_7

# FIG_8